# EUROPEAN PATENT APPLICATION

(11) **EP 4 170 685 A1**
(43) Date of publication of application: **26.04.2023**
(21) Application number: 20944347.2
(22) Date of filing: 09.07.2020
(51) Int. Cl.: H01B 13/00, H01B 7/00

(54) **BUS BAR ASSEMBLY AND METHOD FOR MANUFACTURING SAME**

(71) Applicant: Suncall Corporation, Kyoto-shi, Kyoto 615-8555 (JP)
(72) Inventor: KOBAYAKAWA, Hiroya, kyoto-shi, Kyoto 615-8555 (JP)
(74) Representative: Isarpatent
(86) International application number: PCT/JP2020/026788
(87) International publication number: WO 2022/009361

(57) **Abstract**

A busbar assembly of the present invention includes plural conductive busbars (10(1)-(3)) disposed in a common plane with a gap (19), an insulative resin film (20) bonded to upper surfaces of the plural busbars (10(1)-(3)) in a manner to straddle the gap (19), and a rigid frame body (30) bonded to an upper surface of the insulative resin film (20). The frame body (30) is so configured as to be along a peripheral edge area in plan view of a busbar connected body in which the plural busbars (10(1)-(3)) are connected to one another by the insulative resin film (20). The insulative resin film (20) is formed with an opening (21-23) that exposes a predetermined area of the upper surface of the plural busbars (10(1)-(3)).

## Description

### FIELD OF THE INVENTION

The present invention relates to a busbar assembly in which a plurality of busbars are electrically insulated and mechanically connected to one another, and a method for manufacturing the same.

### BACKGROUND ART

Busbar assemblies in which a plurality of busbars are mutually electrically insulated and mechanically connected are proposed, and are used in various fields.

For example, there are proposed laminated-type busbar assemblies in which a first flat plate busbar and another second flat plate busbar in parallel with each other are vertically laminated (see Patent Literatures 1 and 2 below).

In the laminated-type busbar assembly, the entirety of the opposing flat surface of the first flat plate busbar and the entirety of the opposing flat surface of the second flat plate busbar are disposed to face each other with an insulating resin therebetween, it is difficult to ensure sufficient reliability in electric insulating property.

In particular, if the insulating resin between the first and second flat plate busbars is made thin in order to downsize the busbar assembly in the vertical direction, there is a risk that a leakage current flows between the first and second busbars.

In order to solve the problems of the above laminated-type busbar assembly, the present applicant has filed applications for a planar-type busbar assembly in which first and second busbars of conductive metal flat plates are arranged in parallel in a common plane (see Patent Literatures 3 and 4 below).

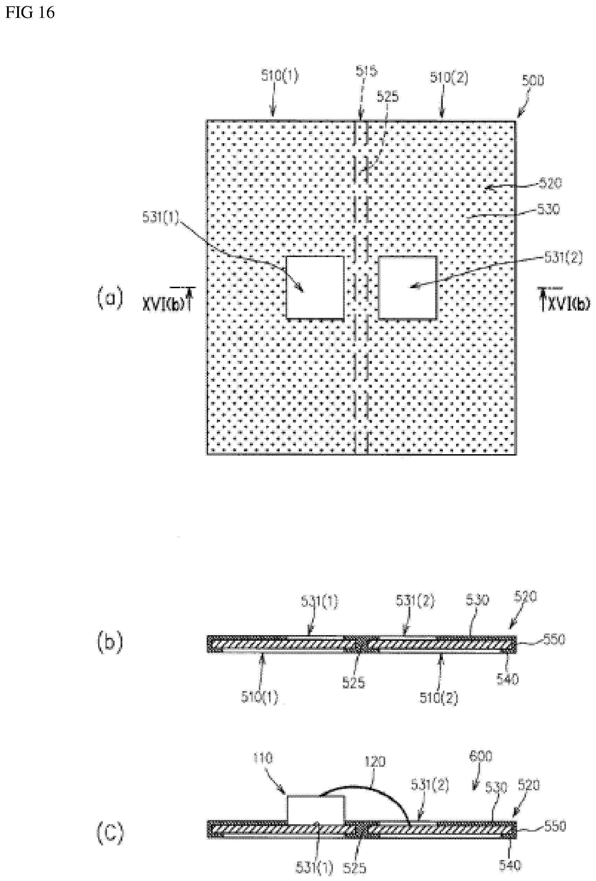

FIG. 16A shows a plan view of an example of a planar-type busbar assembly 500.

FIG. 16B shows a cross-sectional view along the line XVI(b)-XVI(b) in FIG. 16A.

As shown in FIGS. 16A and 16B, the planar-type busbar assembly 500 has a first busbar 510(1) formed of a conductive metal flat plate, a second busbar 510(2) formed of a conductive metal flat plate and arranged in a common plane to the first busbar 510(1) with a gap 515 between the first busbar 510(1) and the second busbar 510(2), and an insulative resin layer 520 that mechanically connects the first and second busbars 510(1), 510(2) while electrically insulating them.

The insulative resin layer 520 has a gap filling part 525 filled in the gap 515, and a surface laminated part laminated on a surface of a busbar connecting body where the first and second busbars 510(1), 510(2) are connected by the gap filling part 525.

The surface laminated part includes an upper laminated part 530 and a lower laminated part 540 that cover an upper surface on one side in the thickness direction and a lower surface on the other side in the thickness direction of the busbar connecting body, respectively, and a side surface laminated part 550 that covers an outside surface of the busbar connecting body and connects the upper and lower laminated parts 530, 540.

The upper laminated part 530 has first and second openings 531(1), 531(2) that expose predetermined parts of the upper surfaces of the first and second busbars 510(1), 510(2), respectively, thereby to form first and second exposed areas.

FIG. 16C shows a vertical cross-sectional view of a semiconductor module 600 in which a semiconductor element 110 such as an LED is mounted on the busbar assembly 500.

As shown in FIG. 16C, the semiconductor element 110 has an element body (not shown), and an upper electrode layer and a lower electrode layer (not shown) that are arranged on one side and the other side in a thickness direction of the element body. As shown in FIG. 16C, the lower electrode layer is mechanically and electrically connected to one of the first and second exposed areas (in FIG. 16C, the first exposed area) via, for example, a plating layer (not shown), and the upper electrode layer is electrically connected to the other of the first and second exposed areas (in FIG. 16C, the second exposed area) via a wire bonding 120.

The planar busbar assembly 500 disclosed in the Patent Literatures 3 and 4 is useful in being capable of solving the problems of the above laminated-type busbar assembly, but has still room for improvement in terms of manufacturing efficiency.

That is, in order to manufacture the planar-type busbar assembly 500 disclosed in the Patent Literatures 3 and 4, it is needed to fill an insulating resin in the gap 515 between the first and second busbars 510(1), 510(2) and another second flat plate arranged in a common plane to form the gap filling part 525.

Here, in order to downsize the planar-type busbar assembly 500 in the plane direction, it is needed to reduce an opening width of the gap 515 as much as possible. However, the reduction of the opening width of the gap 515 makes it difficult to fill the insulating resin into the gap 515.

### PRIOR ART DOCUMENT

### Patent Literature

Patent Literature 1: Japanese Patent No. 4432913
Patent Literature 2: Japanese Patent No. 6487769
Patent Literature 3: Japanese Patent No. 6637002
Patent Literature 4: Japanese Patent No. 6637003

### SUMAARY OF THE INVENTION

The present invention has been made in view of the conventional art, and it is an object of the present invention to provide a busbar assembly in which plural busbars are arranged in a common plane with a gap between the adjacent busbars, the busbar assembly capable of enhancing the freedom degree of an opening width of the gap and also improving the manufacturing efficiency, and a manufacturing method for the busbar assembly.

In order to achieve the object, a first aspect of the present invention provides a busbar assembly including a plurality of busbars formed by a conductive flat plate-like member and disposed in a common plane with a gap provided between opposing lateral surfaces of the adjacent busbars; and an insulative resin film bonded to upper surfaces of the plural busbars in a manner to straddle the gap to connect the plural busbars with the gap present; wherein the insulative resin film is formed with an opening that exposes a predetermined area of the upper surface of the plural busbars.

The busbar assembly according to the first aspect of the present invention can arbitrarily set the opening width of the gap and can be efficiently manufactured, since the plural busbars, which are arranged in the common plane with the gap being present between the opposing lateral surfaces of the adjacent busbars, are connected to one another by the insulative resign film.

The busbar assembly according to the first aspect preferably further includes a frame body formed by a rigid member and bonded to an upper surface of the insulative resin film, wherein the frame body is so configured as to be along a peripheral edge area in plan view of a busbar connected body in which the plural busbars are connected to one another by the insulative resin film.

The busbar assembly with the frame body can enhance the strength of the busbar assembly and effectively prevent a sealing resin from flowing out in a time when the sealing resin is filled, the sealing resin being provided for sealing a semiconductor element such as a LED mounted on the busbar.

In a more preferably embodiment, the frame body is formed by the material same as the busbar.

In order to achieve the object, a second aspect of the present invention provides a busbar assembly including plural busbars formed by a conductive flat plate-like member and disposed in a common plane with a gap provided between opposing lateral surfaces of the adjacent busbars; and an insulative resin film bonded to lower surfaces of the plural busbars in a manner to straddle the gap to connect the plural busbars with the gap present.

The busbar assembly according to the second aspect of the present invention can arbitrarily set the opening width of the gap and can be efficiently manufactured, since the plural busbars, which are arranged in the common plane with the gap being present between the opposing lateral surfaces of the adjacent busbars, are connected to one another by the insulative resign film.

The busbar assembly according to the second aspect preferably further includes a frame body formed by a rigid member and bonded to upper surfaces of the plural busbars, wherein the frame body is so configured as to be along the peripheral edge area in plan view of a busbar connected body in which the plural busbars are connected to one another by the insulative resin film and have an insulative property at least on an outer surface thereof.

The busbar assembly with the frame body can enhance the strength of the busbar assembly and effectively prevent a sealing resin from flowing out in a time when the sealing resin is filled, the sealing resin being provided for sealing a semiconductor element such as a LED mounted on the busbar.

In order to achieve the object, a third aspect of the present invention provides a method for manufacturing a busbar assembly including a plurality of busbars formed by a conductive flat plate-like member and disposed in a common plane with a gap provided between opposing lateral surfaces of the adjacent busbars, and an insulative resin film bonded to upper surfaces of the plural busbars in a manner to straddle the gap to connect the plural busbars with the gap present, the insulative resin film being formed with an opening that exposes a predetermined area of the upper surface of the plural busbars, the method including: a step for preparing a busbar-directed conductive metal flat plate having a busbar assembly forming area that forms the plural busbars; a slit forming step for forming, in the busbar assembly forming area, one or plural slits penetrating between a first surface on one side of the thickness direction and a second surface on another side in the thickness direction so as to form plural busbar forming sites respectively corresponding to the plural busbars, the slit having the same width as that of the gap; a film bonding step for bonding the insulative resin film to the first surface of the busbar assembly forming area; a cutting step for cutting the busbar assembly forming area from the busbar-directed conductive metal flat plate; and an opening forming step for forming the opening that is performed before the film bonding step, after the film bonding step and before the cutting step, or after the cutting step.

The manufacturing method according to the third aspect preferably further includes a frame body forming process performed before, after or in parallel with a process from the step for preparing the busbar-directed conductive metal flat plate until the film bonding step, the frame body forming process including a step for preparing a rigid frame body-directed flat plate that includes a frame body forming area having an outer shape that corresponds, in plan view, to the busbar assembly forming area, and a punching step for punching out a center of the frame body forming area to form a frame body; and a flat plate bonding step that overlaps the frame body-directed flat plate in the state after the frame body forming process with the busbar-directed conductive metal flat plate in the state after the film bonding step, and then bonds the frame body forming area to the first surface of the corresponding busbar assembly forming area.

In this case, the cutting step is configured to cut, after the flat plate bonding step, the busbar assembly forming area and the frame body forming area, which are bonded with each other, from the busbar-directed conductive metal flat plate and the frame body-directed flat plate.

In one embodiment of the third aspect, the opening forming step is so configured as to form the opening by punching the insulating film in the state before the film boding step.

In another embodiment, the opening forming step is so configured as to form the opening by irradiating the insulative resin film with a laser beam or by performing an etching the insulative resin film.

In order to achieve the object, a fourth aspect of the present invention provides a method for manufacturing a busbar assembly including a plurality of busbars formed by a conductive flat plate-like member and disposed in a common plane with a gap provided between opposing lateral surfaces of the adjacent busbars, and an insulative resin film bonded to lower surfaces of the plural busbars in a manner to straddle the gap to connect the plural busbars with the gap present, the method including: a step for preparing a busbar-directed conductive metal flat plate having a busbar assembly forming area that forms the plural busbars; a slit forming step for forming, in the busbar assembly forming area, one or plural slits penetrating between a first surface on one side of the thickness direction and a second surface on another side in the thickness direction so as to form plural busbar forming sites respectively corresponding to the plural busbars, the slit having the same width as that of the gap; a film bonding step for bonding the insulative resin film to the second surface of the busbar assembly forming area; and a cutting step for cutting the busbar assembly forming area from the busbar-directed conductive metal flat plate.

The manufacturing method according to the fourth aspect preferably further includes a frame body forming process performed before, after or in parallel with a process from the step for preparing the busbar-directed conductive metal flat plate until the film bonding step, the frame body forming process including a step for preparing a rigid frame body-directed flat plate that includes a frame body forming area having an outer shape that corresponds, in plan view, to the busbar assembly forming area, a punching step for punching out a center of the frame body forming area to form a frame body, and a resin layer providing step for providing an insulative resin layer on an outer peripheral surface of the frame body; and a flat plate bonding step that overlaps the frame body-directed flat plate in the state after the frame body forming process with the busbar-directed conductive metal flat plate in the state after the film bonding step with, and then bonds the frame body forming area to the first surface of the corresponding busbar assembly forming area.

In this case, the cutting step is configured to cut, after the flat plate bonding step, the busbar assembly forming area and the frame body forming area, which are bonded with each other, from the busbar-directed conductive metal flat plate and the frame body-directed flat plate.

In a preferable embodiment of the manufacturing method according to the third or fourth aspects, the busbar-directed conductive metal flat plate integrally includes the plural busbar assembly forming areas arranged in series in a first direction along the longitudinal direction of the slit, and connection areas each of which connects between the adjacent busbar assembly forming areas.

In this case, the slit formed in one busbar assembly forming area has one side in the longitudinal direction extending into one connection area connected to one side of the one busbar assembly forming area in the first direction, and another side in the longitudinal direction extending into another connection area connected to another side of the one busbar assembly forming area in the first direction.

In a manufacturing method including the frame body forming process among the manufacturing method according to the third or fourth aspects, the frame body-directed flat plate preferably integrally includes the plural frame body forming areas arranged in series in the first direction at the same pitch as the plural busbar assembly forming areas, and connection areas each of which connects between the frame body forming areas adjacent in the first direction.

### BRIEF DESCRIPTION OF THE DRAWINGS

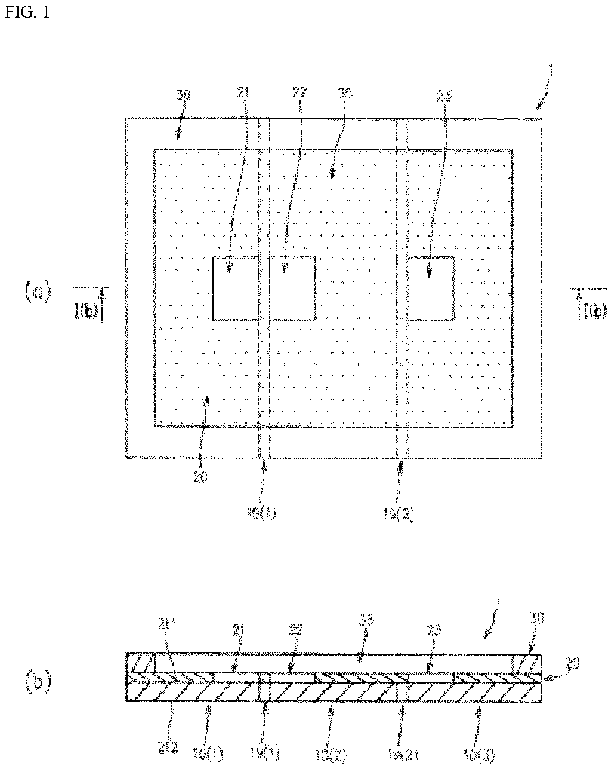

[FIG. 1]
   FIG.. 1A is a plan view of a busbar assembly according to a first embodiment of the present invention, and FIG. 1B is a cross-sectional view along the line I(b)- I(b) in FIG. 1A.
[FIG. 2]

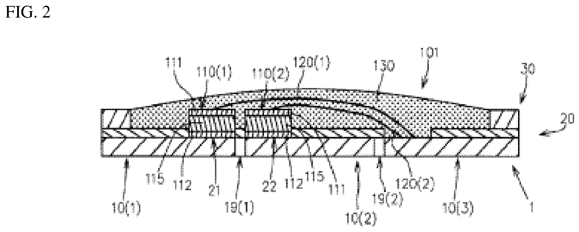

   FIG. 2 is a vertical cross-sectional view of a semiconductor module in which semiconductor elements such as LED are mounted on the busbar assembly according to the first embodiment.
[FIG. 3]

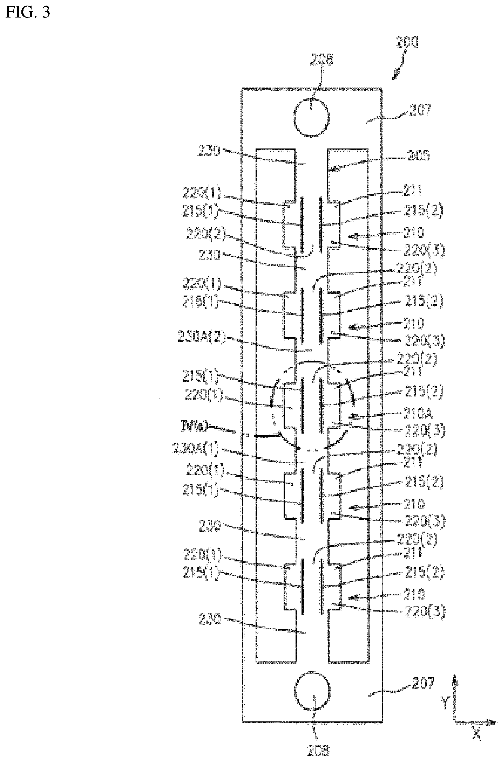

   FIG. 3 is a plan view of a busbar-directed conductive metal flat plate used in one example (hereinafter referred to as 1st manufacturing method) of a method for manufacturing the busbar assembly according to the first embodiment.
[FIG. 4]

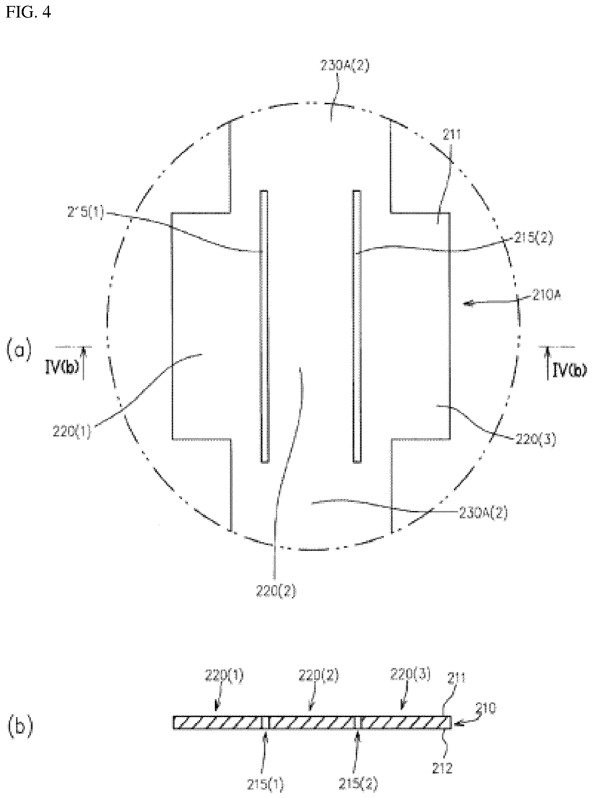

   FIG. 4A is an enlarged view of the IV(a) section in FIG. 3, and FIG. 4B is a cross-sectional view along the line IV(b)-VII(b) in FIG. 4A.
[FIG. 5]

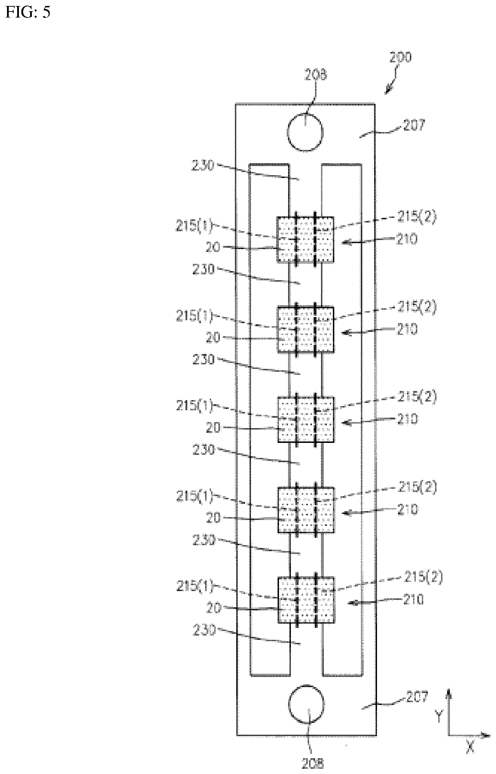

   FIG. 5 is a plan view of the busbar-directed conductive metal flat plate acquired after the film bonding step in the 1st manufacturing method.
[FIG. 6]

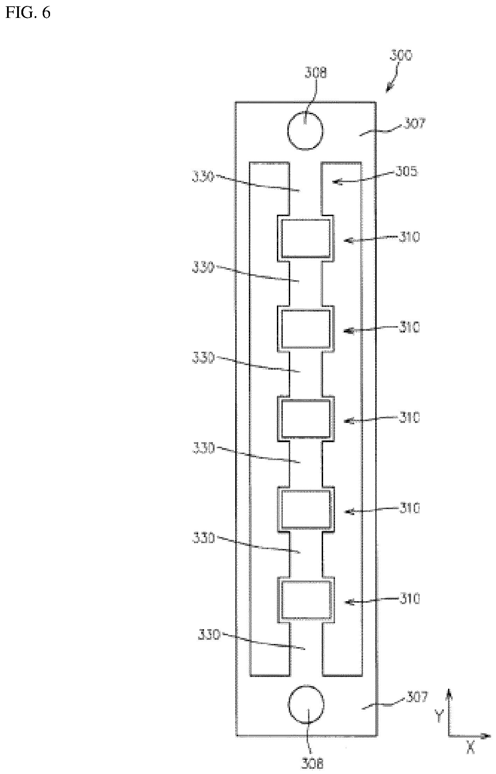

   FIG. 6 is a plan view of a frame body-directed flat plate used in a frame body forming process in the first manufacturing method.
[FIG. 7]

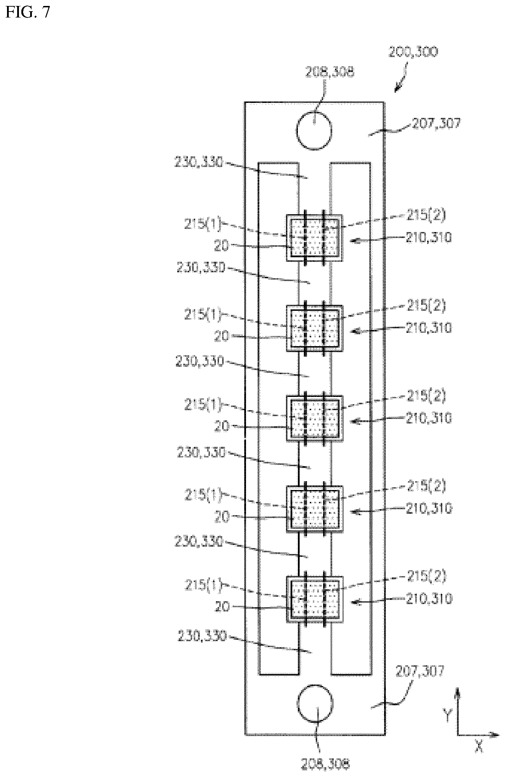

   FIG. 7 is a plan view of the busbar-directed conductive metal flat plate and the frame body-directed flat plate in a state a flat plate bonding step in the first manufacturing method.
[FIG. 8]

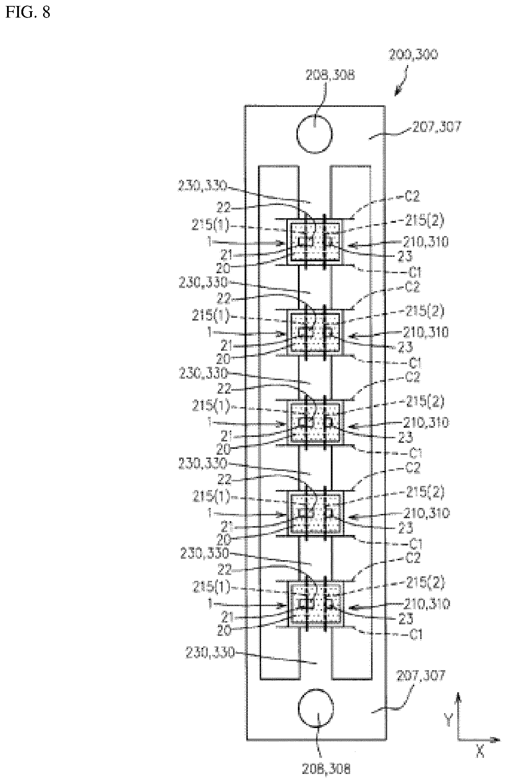

   FIG. 8 is a plan view of the busbar-directed conductive metal flat plate and the frame body-directed flat plate in a state after an opening forming step in the first manufacturing method.
[FIG. 9]

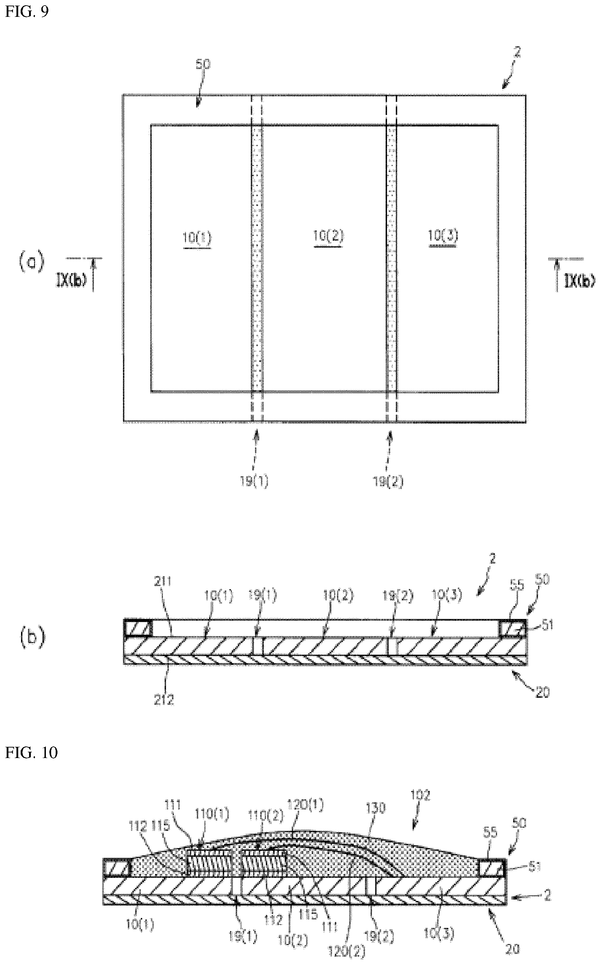

   FIG. 9A is a plan view of a busbar assembly according to a second embodiment of the present invention, and FIG. 9B is a cross-sectional view along the line IX(b)- IX(b) in FIG. 9A.
[FIG. 10]
   FIG. 10 is a vertical cross-sectional view of a semiconductor module in which semiconductor elements such as LED are mounted on the busbar assembly according to the second embodiment.
[FIG. 11]

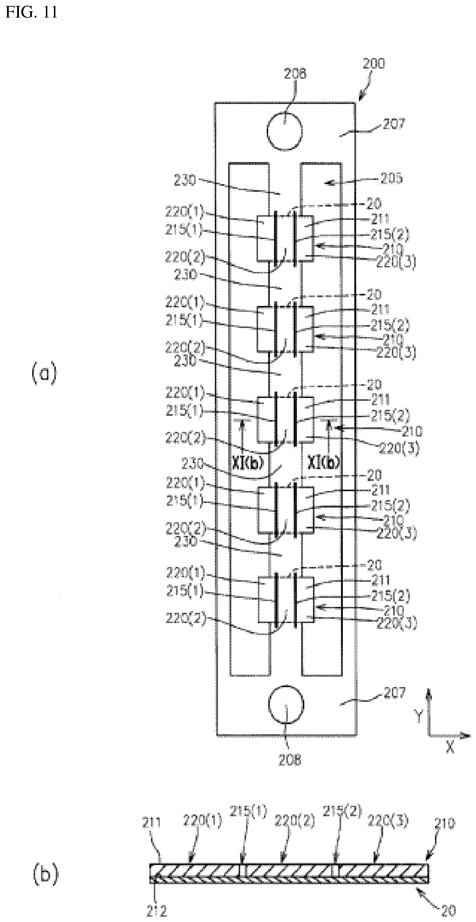

   FIG. 11A is a plan view of a busbar-directed conductive metal flat plate used in one example (hereinafter referred to as second manufacturing method) of a method for manufacturing the busbar assembly according to the second embodiment, and FIG. 11B is an enlarged cross-sectional view along the line XI(b)-XI(b) in FIG. 11A, FIGS. 11A and 11B showing the state seen after completion of a film bonding step in the second manufacturing method.
[FIG. 12]

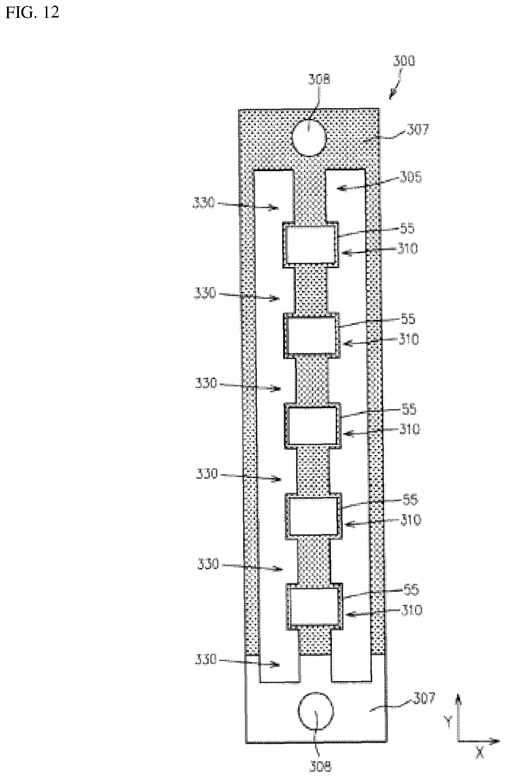

   FIG. 12 is a plan view of a frame body-directed flat plate used in the second manufacturing method, and shows the state after a resin layer providing step in the second manufacturing method.
[FIG. 13]

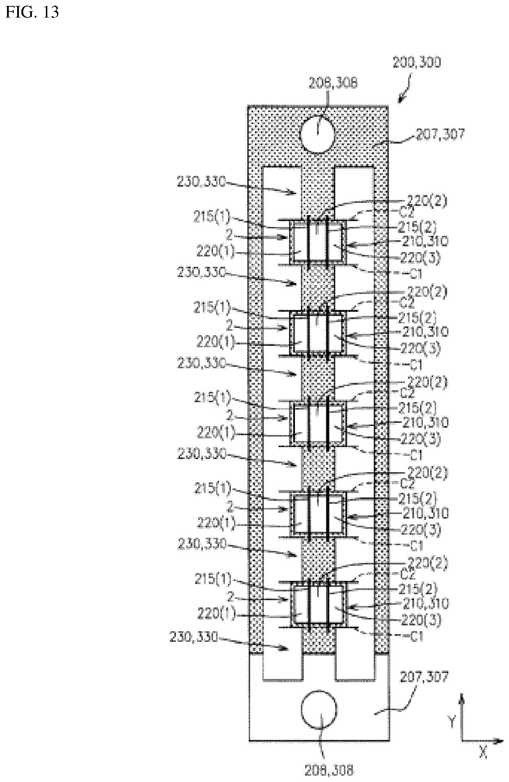

   FIG. 13 is a plan view of the busbar-directed conductive metal flat plate and the frame body-directed flat plate which are in the state after a flat plate bonding step in the second manufacturing method.
[FIG. 14]

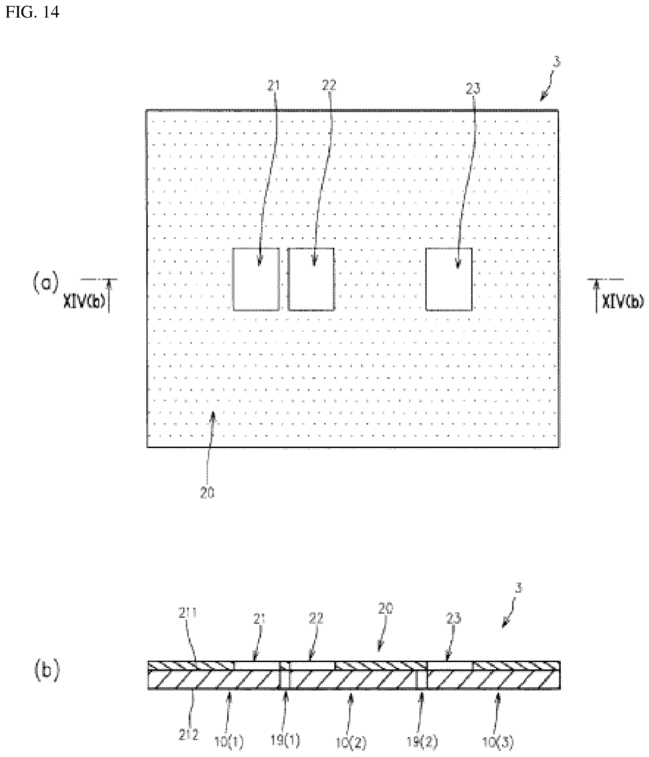

   FIG. 14A is a plan view of a busbar assembly according to a third embodiment of the present invention, and FG. 14B is a cross-sectional view along the line XIV(b)-XIV(b) in FIG. 14A.
[FIG. 15]

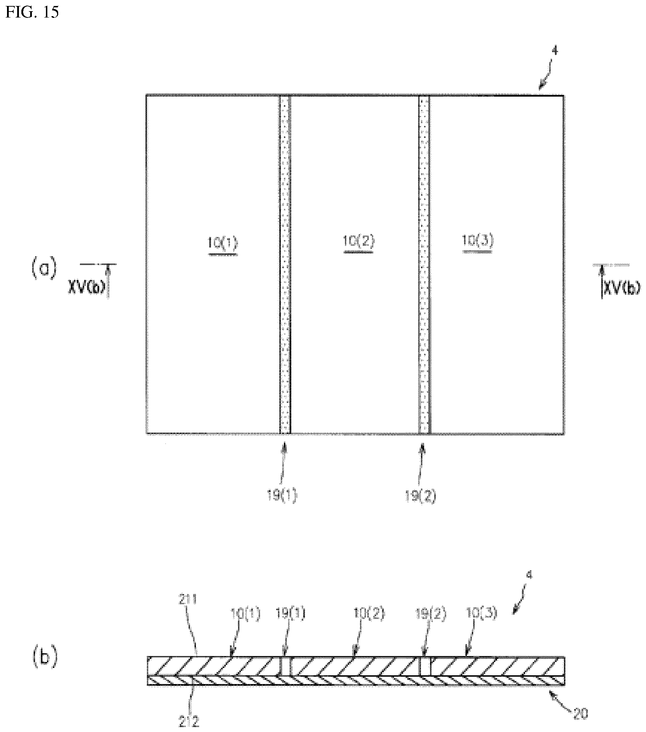

   FIG. 15A is a plan view of a busbar assembly according to a fourth embodiment of the present invention, and FIG. 15B is a cross-sectional view along the line XV(b)-XV(b) in FIG. 15A.
[FIG. 16]
   FIG. 16A is a plan view of a conventional planar-type busbar assembly, FIG. 16B is a cross-sectional view along the line XVI(b)-XVI(b) in FIG. 16A, and FIG. 16C is a vertical cross-sectional view of a semiconductor module in which a semiconductor element such as LED is mounted on the conventional busbar assembly.

### EMBODIMENT FOR CARRYING OUT THE INVENTION

### First Embodiment

One embodiment of a busbar assembly according to the present invention will be described below with reference to the accompanying drawings.

FIG. 1A shows a plan view of a busbar assembly 1 according to the present embodiment.

Further, FIG. 1B shows a cross-sectional view along the line I(b)- I(b) in FIG. 1A.

As shown in FIGS. 1A and 1B, the busbar assembly 1 has a plurality of busbars 10 formed by a conductive flat plate-like member and placed in a common plane with a gap 19 present between opposing lateral surfaces, an insulative resin film 20 bonded to upper surfaces of the plural busbars 10 in a manner to straddle the gap 19 to connect the plural busbars 10 with the gap 19 present, and a frame body 30 formed by a rigid member, and bonded to an upper surface (opposite a lower surface bonded to the plural busbars 10) of the insulative resin film 20.

The busbar 10 is formed by a conductive metal such as Cu.

The busbar assembly 1 according to the present embodiment has, as the plurality of busbars 10, 1st to 3rd busbars 10(1) to 10(3) three in number, and has, as the gaps 19, 1st and 2nd gaps 19(1), 19(2).

That is, the busbar assembly 1 has the 1st busbar 10(1), the 2nd busbar 10(2) placed adjacent to the 1st busbar 10(1) via the 1st gap 19(1), and the 3rd busbar 10(3) placed adjacent to the 2nd busbar 10(2) via the 2nd gap 19(2).

In the vertical cross sectional view shown in FIG. 1(b), each of the busbars 10(1) to 10(3) has the upper surface to which the insulative resin film 20 is bonded, a lower surface opposite the upper surface, and the lateral surface that, while the gap 19 being present therein, opposes any of the other adjacent busbars 10(1) to 10(3).

The insulative resin film 20 is formed by various materials that have an insulative property and also have a strength capable of connecting the plural busbars 10, and preferably uses polyamide-imide.

The frame body 30 is so configured as to be along a peripheral edge area in plan view of a busbar connected body which body including the plural busbars 10 connected by the insulative resin film 20.

That is, the frame body 30 has a central opening 35 that upward opens the central area of the busbar connected body.

As long as having the rigidity capable of holding the busbar connected body in cooperation with the insulative resin film 20, the frame body 30 is formed by various materials such as Cu, stainless steel, ceramic, etc., and preferably, is formed by the material same as that of the busbar 10.

As shown in FIGS. 1A and 1B, the insulative resin film 20 has openings that expose predetermined areas of the upper surfaces of the plural busbars 10.

As described above, the busbar assembly according to the present embodiment has the 1st to 3rd busbars 10(1) to 10(3).

Therefore, the insulative resin film 20 has a 1st busbar-directed opening 21 that exposes a predetermined area of the upper surface of the 1st busbar 10(1), a 2nd busbar-directed opening 22 that exposes a predetermined area of the upper surface of the 2nd busbar 10(2), and a 3rd busbar-directed opening 23 that exposes a predetermined area of the upper surface of the 3rd busbar 10(3).

FIG. 2 shows a vertical cross-sectional view of an example of a semiconductor module 101 in which a semiconductor element 110 such as an LED is fixed to the busbar assembly 1.

The semiconductor module 101 has, as semiconductor elements 110, 1st and 2nd semiconductor elements 110(1), 110(2).

Each of the 1st and 2nd semiconductor elements 110(1), 110(2) has an upper electrode layer and a lower electrode layer 111, 112 on the upper surface on one side in the thickness direction and on the lower surface on the other side in the thickness direction, respectively, and an element body 115 between the upper and lower electrode layers 111, 112.

In the semiconductor module 101, the 1st and 2nd busbars 10(1) and 10(2) each act as a 1st electrode which is one (e.g., positive electrode) of the positive and negative electrodes, and the 3rd busbar 10(3) acts as the 2nd electrode which is another (e.g., negative electrode) of the positive and negative electrodes.

That is, in the 1st semiconductor element 110(1), the lower electrode layer 112, in a state of being electrically connected, is fixed to an area, which is exposed through the 1st busbar-directed opening 21, out of the upper surface of the 1st busbar 10(1) acting as the 1st electrode, and the upper electrode layer 111, via a 1st electrical connection member 120(1) such as wire bonding, is electrically connected to an area, which is exposed through the 3rd busbar-directed opening 23, out of the upper surface of the 3rd busbar 10(3) acting as the 2nd electrode.

In the 2nd semiconductor element 110(2), the lower electrode layer 112, in a state of being electrically connected, is fixed to an area, which is exposed through the 2nd busbar-directed opening 22, out of the upper surface of the 2nd busbar 10(2) acting as the 1st electrode, and the upper electrode layer 111, via a 2nd electrical connection member 120(2) such as wire bonding, is electrically connected to an area, which is exposed through the 3rd busbar-directed opening 23, out of the upper surface of the 3rd busbar 10(3) acting as the 2nd electrode.

Preferably, the upper surfaces of the 1st to 3rd busbars 10(1) to 10(3) are provided with plating layers (not shown).

In this case, the lower electrode layers 112 of the 1st and 2nd semiconductor elements 110(1), 110(2) are, respectively, so die-bonded as to be electrically connected to the plating layers on the upper surfaces of the 1st and 2nd busbars 10(1), 10(2), and the upper electrode layers 111 of the 1st and 2nd semiconductor elements 110(1), 110(2) are, respectively, so wire-bonded by the 1st and 2nd electrical connection members 120(1), 120(2) as to be electrically connected to a plating layer (not shown) provided on the upper surface of the 3rd busbar 10(3).

A reference numeral 130 in FIG. 2 is a sealing resin layer fixed to the upper surface of the busbar assembly 1 in order to protect components such as the 1st and 2nd semiconductor elements 110(1), 110(2) and the 1st and 2nd electrical connection members 120(1), 120(2), each of which fitted to the busbar assembly 1.

When the sealing resin layer 130 is provided, the frame body 30 prevents a resin material, which forms the sealing resin layer 130, from flowing out before curing.

The sealing resin layer 130 is formed, for example, by a transparent resin material such as polyimide, polyamide, epoxy, etc.

The busbar assembly 1 with the above configuration, due to the 1st to 3rd busbars 10(1) to 10(3) being placed in the common plane, can be as small possible in the vertical direction (thickness direction).

According to the busbar assembly 1, the adjacent busbars 10 are so placed as to oppose each other on the lateral surfaces, which makes an opposing area between adjacent busbars as small as possible compared to a laminated-type busbar assembly in which a plurality of busbars are vertically laminated; this effectively prevents a leak current from flowing between the adjacent busbars 10, or effectively reduces the leak current.

Further, the busbar assembly 1 realizes an effect that, compared with a configuration in which holding of the relative position of the plural busbars placed in the common plane with the gap present between the adjacent busbars is performed by an insulative resin filled in the gap (hereinafter referred to as "comparative configuration"), the freedom degree of the opening width of the gap 19 can be enhanced, and the manufacturing efficiency can be improved.

That is, in the comparative configuration, excessively narrowing the opening width of the gap in order to downsize the entire busbar assembly in the planar direction makes it difficult or, as the case may be, impossible, due to the surface tension of the insulative resin material, to perform the work of filling the insulative resin material into the gap.

On the other hand, in the busbar assembly 1 according to the present embodiment, holding of relative position of the 1st to 3rd busbars 10(1) to 10(3) placed in the common plane with the gap 19 present between the adjacent busbars is performed by the insulative resin film 20 bonded to the upper surfaces of the 1st to 3rd busbars 10(1) to 10(3), and by the frame body 30 bonded to the upper surface of the insulative resin film 20.

That is, in the busbar assembly 1 according to the present embodiment, there is no need for filling the gap 19 with the insulative resin material, thus making it possible to enhance the freedom degree of the opening width of the gap 19, and to improve the manufacturing efficiency.

Also, in the busbar assembly 1 according to the present embodiment, the lower surfaces of the 1st to 3rd busbars 10(1) to 10(3) are entirely exposed.

Thus, in a case where the busbar assembly 1 is used as the semiconductor module 101, the heat dissipation characteristics via the lower surfaces of the 1st to 3rd busbars 10(1) to 10(3) can be improved.

The following is one example (1st manufacturing method) of the manufacturing method of the busbar assembly 1.

FIG. 3 shows a plan view of a busbar-directed conductive metal flat plate 200 used in the 1st manufacturing method.

Also, FIG. 4A shows an enlarged view of the IV(a) section in FIG. 3, and FIG. 4B shows a cross-sectional view along the line IV(b)-VII(b) in FIG. 4A.

As shown in FIG. 3 and FIG. 4, the 1st manufacturing method has a step for preparing the busbar-directed conductive metal flat plate 200 having busbar assembly forming areas 210 same in thickness as the 1st to 3rd busbars 10(1) to 10(3), and a slit forming step for forming, in each of the busbar assembly forming areas 210, a slit 215 penetrating between a 1st surface 211 on one side of the thickness direction and a 2nd surface 212 on another side in the thickness direction.

FIG. 3 shows a state after the completion of the slit forming step.

As described above, the busbar assembly 1 according to the present embodiment has, as of the plural busbars 10, the three busbars including the 1st to 3rd busbars 10(1) to 10(3). Thus, in the busbar assembly forming area 210, 1st and 2nd slits 215(1), 215(2) are each formed as the slit 215.

For example, for manufacturing the busbar assembly including two busbars placed in parallel, one slit is formed.

As shown in FIG. 3 and FIG. 4A, in the present embodiment, the busbar-directed conductive metal flat plate 200 has a busbar row 205 that includes the plural busbar assembly forming areas 210 placed in series along the line Y direction in the X-Y plane where the conductive metal flat plate 200 is positioned, and connection areas 230 each of which connects between the busbar assembly forming areas 210 adjacent in the Y direction, so that a process can be performed simultaneously for the plural busbar assembly forming areas 210.

In the present embodiment, the busbar-directed conductive metal flat plate 200 has a pair of grip pieces 207 connected to one side and another side, respectively, of the busbar row 205 in the longitudinal direction (Y direction), and the pair of grip pieces 207 is provided with positioning holes 208.

It is also possible to place the plural busbar rows 205 in parallel in the X direction and to integrally hold, by the pair of grip pieces 207, 207, the plural busbar rows 205 placed in parallel in the X direction.

According to the above modified configuration, more busbar assemblies 1 can be simultaneously manufactured.

In the present embodiment, the lengths in the X direction and Y direction of the busbar assembly forming area 210 are so set that the length in the Y direction is the same as length of the busbar assembly 1 in the direction parallel to the gap 19, and the length in the X direction is the same as the length of the busbar assembly 1 in the direction orthogonal to the gap 19.

The slits 215(1), 215(2) form the 1st and 2nd gaps 19(1), 19(2), and are of the same in width as the corresponding 1st and 2nd gaps 19(1), 19(2).

The widths of the 1st and 2nd gaps 19(1), 19(2) are determined in accordance with the specification of the busbar assembly 1.

As shown in FIG. 4A, in the present embodiment, the 1st and 2nd slits 215(1), 215(2) formed in one busbar assembly forming area 210A have one side in the longitudinal direction (Y direction) extending into one connection area 230A(1) connected to one side of the one busbar assembly forming area 210A in the longitudinal direction (Y direction), and another side in the longitudinal direction (Y direction) extending into another connection area 230A(2) connected to another side of the one busbar assembly forming area 230A in the longitudinal direction (Y direction).

Then, in the state after the slit forming step, 1st to 3rd busbar forming sites 220(1) to 220(3) adjacent via the 1st and 2nd slits 215(1), 215(2) formed in the one busbar assembly forming area 210A are so configured as to be maintained in a state of being connected to each other via the one connection area 230A(1) and the other connection area 230A(2).

With the above configuration, the 1st and 2nd slits 215 (1), 215(2) (the 1st and 2nd gaps 19(1), 19(2)) can be formed with high precision.

The 1st manufacturing method, after the slit forming step, has a film bonding step for bonding the insulative resin film 20 to the 1st surface 211 (upper surface to which the semiconductor element 110 is mounted) on one side of the busbar assembly forming area 210 in the thickness direction.

FIG. 5 shows a plan view of the busbar-directed conductive metal flat plate 200 acquired after the film bonding step.

As shown in FIG. 5, in the present embodiment, the insulative resin film 20 is the same in external shape in plan view as the busbar forming area 210.

The insulative resin film 20 is formed by an insulative resin material, such as polyamide-imide, polyimide, polyamide, epoxy, etc., having a heat resistance property and an insulative property.

The 1st manufacturing method is so configured as to perform, in parallel with, or before or after the process from the step for preparing the busbar-directed conductive metal flat plate 200 to the film bonding step, a frame body forming process for forming the frame body 30.

FIG. 6 shows a plan view of a frame body-directed flat plate 300 used in the frame body forming process.

The frame body forming process has a step for preparing the frame body-directed flat plate 300 that is the same in thickness as the frame body 30 and that includes a frame body forming area 310 having, in plan view, an outer shape that corresponds to the busbar assembly forming area 210, and a punching step for punching out the center of the frame body forming area 310 so that a frame body formation site corresponding to the frame body 30 remains.

FIG. 6 shows the state acquired after the punching process.

The frame body-directed flat plate 300 is formed by various rigid materials.

Preferably, the frame body-directed flat plate 300 is formed by a material same as that of the busbar-directed conductive metal flat plate 200.

The frame body-directed flat plate 300 is so configured that, when the frame body-directed flat plate 300 is overlapped with the busbar-directed conductive metal flat plate 200, the frame body forming area 310 is aligned with the busbar assembly forming area 210.

In detail, as described above, the busbar-directed conductive metal flat plate 200 has the busbar row 205 that includes the plural busbar assembly forming areas 210 placed in series along the line Y direction, and the connection areas 230 each of which connects between the busbar assembly forming areas 210 adjacent in the Y direction.

Thus, as shown in FIG. 6, the frame body-directed flat plate 300 has a frame body row 305 including the plural frame body forming areas 310 placed in series in the Y direction at the same pitch as the plural busbar assembly forming areas 210, and connection areas 330 each of which connects between the frame body forming areas 310 adjacent in the Y direction.

As described above, the busbar-directed conductive metal flat plate 200 has the pair of grip pieces 207 which are connected to one side and another other side, respectively, of the busbar row 205 in the longitudinal direction (Y direction), and the pair of grip pieces 207 is provided with the positioning holes 208.

Corresponding to this, as shown in FIG. 6, the frame body-directed flat plate 300 is also provided with a pair of grip pieces 307 connected to one side and another side, respectively, of the frame body row 305 in the longitudinal direction (Y direction), and the pair of grip pieces 307 is provided with positioning holes 308 corresponding to the positioning holes 208.

The 1st manufacturing method has a flat plate bonding step that overlaps the busbar-directed conductive metal flat plate 200 with the frame body-directed flat plate 300, and bonds the frame body forming area 310 to the 1st surface 211 of the corresponding busbar assembly forming area 210.

FIG. 7 shows a plan view of the busbar-directed conductive metal flat plate 200 and the frame body-directed flat plate 300 which are seen in the state after the flat plate bonding step.

The 1st manufacturing method further has an opening forming step to expose predetermined areas of the 1st surfaces of the 1st to 3rd busbars 10(1) to 10(3).

In the present embodiment, the opening forming step is so configured as to irradiate the insulative resin film 20, which is acquired after the flat bonding step, with a laser beam thereby to form a desired opening (the 1st to 3rd busbar-directed openings 21 to 23 in the present embodiment).

FIG. 8 shows a plan view of the busbar-directed conductive metal flat plate 200 and the frame body-directed flat plate 300 which are seen in the state after the opening forming step.

The 1st manufacturing method further has a cutting step for cutting the busbar assembly forming area 210 and the frame body forming area 310, which are in the bonded state, from the busbar-directed conductive metal flat plate 200 and the frame body-directed flat plate 300.

As shown in FIG. 8, the cutting step is so configured as to cut by cutting lines C1, C2 along one side edge and another side edge in the Y direction, respectively, of the busbar assembly forming area 210 and frame body forming area.

In the present embodiment, the opening forming step is performed after the flat bonding step and before the cutting step, but alternatively, the opening forming step can be so configured as to be performed for the insulative resin film 20 which is seen before the film bonding step, that is, before the insulative resin film 20 is bonded to the busbar assembly forming area 210.

In this case, the film bonding step is so configured as to bond the insulative resin film 20, which is in a state of being formed with the opening, to the busbar assembly forming area 210.

Or, the laser beam irradiation to the insulative resin film 20 can be performed after the film bonding step and before the flat plate bonding step (state shown in FIG. 5), or after the cutting step.

In the present embodiment, the opening is formed by the laser irradiation, but alternatively, the opening can be formed by an etching.

In this case, the opening is formed by performing the etching in a state of masking an area out of the insulative resin film 20 other than an area at which the opening should be formed.

Further, in the case where the opening forming step is performed before the film bonding step, it is also possible to form the opening by punching the insulative film 20.

### Second Embodiment

Another embodiment of the busbar assembly according to the present invention will be described below with reference to the accompanying drawings.

FIG. 9A shows a plan view of a busbar assembly 2 according to the present embodiment.

Also, FIG. 9B shows a cross-sectional view along the line IX(b)- IX(b) in FIG. 9A.

Further, FIG. 10 shows a vertical cross-sectional view of a semiconductor module 102 in which the 1st and 2nd semiconductor elements 110(1), 110(2) are mounted on the busbar assembly 2.

In the figures, the same reference numerals are given to the same members as those in the 1st embodiment, and the description thereof are omitted as appropriate.

As shown in FIG. 9B and FIG. 10, in the busbar assembly 2 according to the present embodiment, the insulative resin film 20 is bonded to the lower surfaces of the plural busbars 10(1) to 10(3).

In detail, the busbar assembly 2 has the plural busbars 10(1) to 10(3), the insulative resin film 20 bonded to the lower surfaces (a surface opposite the upper surface to which the 1st and 2nd semiconductor elements 110(1), 110(2) are mounted) of the plural busbars 10(1) to 10(3) in a manner to straddle the gaps 19(1), 19(2) thereby to connect the plural busbars 10(1) to 10(3) with the gaps 19(1), 19(2) present, and the frame body 50 formed by a rigid member and bonded to the upper surfaces of the plural busbars 10(1) to 10(3).

As shown in FIG. 9(a), the frame body 50 is so configured as to be along the peripheral edge area in plan view of the busbar connected body, which includes the plural busbars 10(1) to 10(3) connected by the insulative resin film 20, and the frame body 50 has an insulative property at least on an outer surface thereof.

The frame body 50 having the insulative property at least on the outer surface thereof includes a configuration formed entirely of ceramic, as well as a configuration having a frame body formed by a conductive member such as Cu or stainless steel, and an insulative resin layer covering the outer surface of the frame body.

As shown in FIG. 9B and FIG. 10; in the present embodiment, the frame body 50 has a frame body 51 formed by a conductive member such as Cu or stainless steel, and an insulative resin layer 55 covering the outer surface of the frame body 51.

The insulative resin layer 55 is formed by using, for example, an insulative resin material such as polyimide, polyamide, epoxy, etc.

In accordance with need or desire, the insulative resin film 20 may be provided with an opening (not shown) to expose a predetermined area of the lower surfaces of the plural busbars (the 1st to 3rd busbars 10(1) to 10(3)).

The following is a description of the manufacturing method (2nd manufacturing method) of the busbar assembly 2.

FIG. 11A shows a plan view of the busbar-directed conductive metal flat plate 200 used in the 2nd manufacturing method.

Further, FIG. 11B shows an enlarged cross-sectional view along the line XI(b)-XI(b) in FIG. 11A.

The 2nd manufacturing method has a step for preparing the busbar-directed conductive metal flat plate 200, the slit forming step for forming the slit 215 (the 1st and 2nd slits 215(1), 215(2)) in the busbar assembly forming area 210, and the film bonding step for bonding the insulative resin film 20 to the 2nd surface 212 (the lower surface opposite the upper surface to which the semiconductor elements 110(1), 110(2) are mounted) on the other side of busbar assembly forming area 210 in the thickness direction.

FIGS. 11A and 11B show the state seen after completion of the film bonding step.

The 2nd manufacturing method is so configured as to perform, in parallel with, or before or after the process from the step for preparing the busbar-directed conductive metal flat plate 200 to the film bonding step, the frame body forming process for forming the frame body 50.

As described above, in the present embodiment, the frame body 50 has the frame body 51 formed by the conductive member, and the insulative resin layer 55 that covers the outer surface of the frame body 51.

The frame body forming process has a step for preparing the frame body-directed flat plate 300, the punching step for punching out the center of the frame body forming area 310 so that a portion corresponding to the frame body 51 remains, and a resin layer providing step for providing the insulative resin layer 55 on the outer peripheral surface of the portion that corresponds to the frame body 51.

FIG. 12 shows a plan view of the frame body-directed flat plate 300 in the state after the resin layer providing step.

The resin layer providing step can be performed by, for example, electrodeposition coating with a paint containing an insulative resin material, such as polyimide, polyamide, or epoxy, having a heat resistance property and an insulation property.

As an alternative, electrostatic powder coating of an insulative resin material powder is also possible.

Or, the paint containing the insulative resin material can be painted by spraying.

The 2nd manufacturing method has a flat plate bonding step for overlapping the busbar-directed conductive metal flat plate 200 with the frame body-directed flat plate 300 in a state of having the insulative resin layer 55, and bonding the frame body forming area 210 to the 1st surface 211 of the corresponding busbar assembly forming area 210.

FIG. 13 shows a plan view of the busbar-directed conductive metal flat plate 200 and the frame body-directed flat plate 300 which are in the state after the flat plate bonding step.

The 2nd manufacturing method further has the cutting step for cutting the busbar assembly forming area 200 and the frame body forming area 300, which are in the bonded state, from the busbar-directed conductive metal flat plate 200 and the frame body-directed flat plate 300 along the cutting lines C1, C2 in FIG. 13.

In accordance with need or desire, the 2nd manufacturing method can be provided with the opening forming step for forming, in the insulative resin film 20, an opening to expose a given area of the lower surfaces of the plural busbars (the 1st to 3rd busbars 10(1) to 10(3)).

The opening forming step in the 2nd manufacturing method is deemed substantially the same as the opening forming step in the 1st manufacturing method.

### Third Embodiment

Hereafter, a still another embodiment of the busbar assembly according to the present invention will be described below with reference to the accompanying drawings.

FIG. 14A shows a plan view of a busbar assembly 3 according to the present embodiment.

FIG. 14B shows a cross-sectional view along the line XIV(b)-XIV(b) in FIG. 14A.

In the figures, the same reference numerals are given to the same members as those in the above embodiments, and the description thereof are omitted as appropriate.

The busbar assembly 3 according to the present embodiment differs from the busbar assembly 1 according to the 1st embodiment only in that the frame body 30 is deleted.

Although being lower in strength than the busbar assembly 1, the busbar assembly 3, compared with the comparative configuration, enhances the freedom degree of the opening width of the gap 19, and improves the manufacturing efficiency.

The busbar assembly 3 according to the present embodiment can be efficiently manufactured, for example, by a manufacturing method that includes the step for preparing the busbar-directed conductive metal flat plate 200, the slit forming step for forming the slits 215(1), 215(2), the film bonding step for bonding the insulative resin film 20 to the 1st surface 211 of the busbar assembly forming area 210, a cutting step for cutting the busbar assembly forming area 210 from the busbar-directed conductive metal flat plate 200, and the opening forming step for forming the openings 21 to 23.

### Fourth Embodiment

Hereafter, a still another embodiment of the busbar assembly according to the present invention will be described below with reference to the accompanying drawings.

FIG. 15A shows a plan view of a busbar assembly 4 according to the present embodiment.

FIG. 15B shows a cross-sectional view along the line XV(b)-XV(b) in FIG. 15A.

In the figures, the same reference numerals are given to the same members as those in the above embodiments, and the description thereof are omitted as appropriate.

The busbar assembly 4 according to the present embodiment differs from the busbar assembly 2 according to the 2nd embodiment only in that the frame body 30 is deleted.

Although being lower in strength than the busbar assembly 2, the busbar assembly 4, compared with the comparative configuration, enhances the freedom degree of the opening width of the gap 19, and improves the manufacturing efficiency.

The busbar assembly according to the present embodiment can be efficiently manufactured, for example, by a manufacturing method that includes the step for preparing the conductive metal flat plate 200, the slit forming step for forming the slits 215(1), 215(2), the film bonding step for bonding the insulative resin film 20 to the 2nd surface 212 of the busbar assembly forming area 210, and the cutting step for cutting the busbar assembly forming area 210 from the busbar-directed conductive metal flat plate 200.

### DESCRIPTION OF THE REFERENCE NUMERALS

- 1-4: busbar assembly
- 10(1)-10(3): 1st to 3rd busbars
- 19: gap
- 20: insulative resin film
- 21-23: 1 st to 3rd busbar-directed opening
- 30, 50: frame body
- 200: busbar-directed conductive metal flat plate
- 210: busbar assembly forming area
- 215(1), (2): 1st and 2nd slits
- 220(1)-(3): 1st to 3rd busbar forming sites
- 300: frame body-directed flat plate
- 310: frame body forming area

## Claims

1. A busbar assembly (1,3) comprising:
a plurality of busbars (10(1)-(3)) formed by a conductive flat plate-like member and disposed in a common plane with a gap (19) provided between opposing lateral surfaces of the adjacent busbars;
an insulative resin film (20) bonded to upper surfaces of the plural busbars (10(1)-(3)) in a manner to straddle the gap (19) to connect the plural busbars (10(1)-(3)) with the gap (19) present; and
the insulative resin film (20) being formed with an opening (21-23) that exposes a predetermined area of the upper surface of the plural busbars (10(1)-(3)).

2. The busbar assembly (1) according to claim 1, further comprising a frame body (30) formed by a rigid member and bonded to an upper surface of the insulative resin film (20),
wherein the frame body (30) is so configured as to be along a peripheral edge area in plan view of a busbar connected body in which the plural busbars (10(1)-(3)) are connected to one another by the insulative resin film (20).

3. The busbar assembly (1) according to claim 2,
wherein the frame body (30) is formed by the material same as the busbar (10(1)-(3)).

4. A busbar assembly (2,4) comprising:
a plurality of busbars (10(1)-(3)) formed by a conductive flat plate-like member and disposed in a common plane with a gap (19) provided between opposing lateral surfaces of the adjacent busbars; and
an insulative resin film (20) bonded to lower surfaces of the plural busbars (10(1)-(3)) in a manner to straddle the gap (19) to connect the plural busbars (10(1)-(3)) with the gap (19) present.

5. The busbar assembly (2) according to claim 1, further comprising a frame body (50) formed by a rigid member and bonded to upper surfaces of the plural busbars (10(1)-(3)),
wherein the frame body (50) is so configured as to be along the peripheral edge area in plan view of a busbar connected body in which the plural busbars (10(1)-(3)) are connected to one another by the insulative resin film (20) and have an insulative property at least on an outer surface thereof.

6. A method for manufacturing a busbar assembly (1,3) including a plurality of busbars (10(1)-(3)) formed by a conductive flat plate-like member and disposed in a common plane with a gap (19) provided between opposing lateral surfaces of the adjacent busbars, and an insulative resin film (20) bonded to upper surfaces of the plural busbars (10(1)-(3)) in a manner to straddle the gap (19) to connect the plural busbars (10(1)-(3)) with the gap (19) present, the insulative resin film (20) being formed with an opening (21-23) that exposes a predetermined area of the upper surface of the plural busbars (10(1)-(3)), the method comprising:
a step for preparing a busbar-directed conductive metal flat plate (200) having a busbar assembly forming area (210) that forms the plural busbars (10(1)-(3));
a slit forming step for forming, in the busbar assembly forming area (210), one or plural slits (215(1), 215(2)) penetrating between a first surface (211) on one side of the thickness direction and a second surface (212) on another side in the thickness direction so as to form plural busbar forming sites (220(1)-220(3)) respectively corresponding to the plural busbars (10(1)-(3)), the slit (215(1), 215(2)) having the same width as that of the gap (19);
a film bonding step for bonding the insulative resin film (20) to the first surface (211) of the busbar assembly forming area (210);
a cutting step for cutting the busbar assembly forming area (210) from the busbar-directed conductive metal flat plate (200); and
an opening forming step for forming the opening (21-23) that is performed before the film bonding step, after the film bonding step and before the cutting step, or after the cutting step.

7. The method for manufacturing the busbar assembly (1) according to claim 6, further comprising:
a frame body forming process performed before, after or in parallel with a process from the step for preparing the busbar-directed conductive metal flat plate (200) until the film bonding step, the frame body forming process including a step for preparing a rigid frame body-directed flat plate (300) that includes a frame body forming area (310) having an outer shape that corresponds, in plan view, to the busbar assembly forming area (210), and a punching step for punching out a center of the frame body forming area (310) to form a frame body (30); and
a flat plate bonding step that overlaps the frame body-directed flat plate (300) in the state after the frame body forming process with the busbar-directed conductive metal flat plate (200) in the state after the film bonding step, and then bonds the frame body forming area (310) to the first surface (211) of the corresponding busbar assembly forming area (210),
wherein the cutting step is configured to cut, after the flat plate bonding step, the busbar assembly forming area (210) and the frame body forming area (310), which are bonded with each other, from the busbar-directed conductive metal flat plate (200) and the frame body-directed flat plate (300).

8. The method for manufacturing the busbar assembly (1,3) according to claim 6 or 7, wherein the opening forming step is so configured as to form the opening (21-23) by punching the insulating film (20) in the state before the film boding step.

9. The method for manufacturing the busbar assembly (1,3) according to claim 6 or 7, wherein the opening forming step is so configured as to form the opening (21-23) by irradiating the insulative resin film (20) with a laser beam or by performing an etching the insulative resin film (20).

10. A method for manufacturing a busbar assembly (2,4) including a plurality of busbars (10(1)-(3)) formed by a conductive flat plate-like member and disposed in a common plane with a gap (19) provided between opposing lateral surfaces of the adjacent busbars, and an insulative resin film (20) bonded to lower surfaces of the plural busbars (10(1)-(3)) in a manner to straddle the gap (19) to connect the plural busbars (10(1)-(3)) with the gap (19) present, the method comprising:
a step for preparing a busbar-directed conductive metal flat plate (200) having a busbar assembly forming area (210) that forms the plural busbars (10(1)-(3));
a slit forming step for forming, in the busbar assembly forming area (210), one or plural slits (215(1), 215(2)) penetrating between a first surface (211) on one side of the thickness direction and a second surface (212) on another side in the thickness direction so as to form plural busbar forming sites (220(1)-220(3)) respectively corresponding to the plural busbars (10(1)-(3)), the slit (215(1), 215(2)) having the same width as that of the gap (19);
a film bonding step for bonding the insulative resin film (20) to the second surface (212) of the busbar assembly forming area (210); and
a cutting step for cutting the busbar assembly forming area (210) from the busbar-directed conductive metal flat plate (200).

11. The method for manufacturing the busbar assembly (2) according to claim 10, further comprising:
a frame body forming process performed before, after or in parallel with a process from the step for preparing the busbar-directed conductive metal flat plate (200) until the film bonding step, the frame body forming process including a step for preparing a rigid frame body-directed flat plate (300) that includes a frame body forming area (310) having an outer shape that corresponds, in plan view, to the busbar assembly forming area (210), a punching step for punching out a center of the frame body forming area (310) to form a frame body (51), and a resin layer providing step for providing an insulative resin layer (55) on an outer peripheral surface of the frame body (51); and
a flat plate bonding step that overlaps the frame body-directed flat plate (300) in the state after the frame body forming process with the busbar-directed conductive metal flat plate (200) in the state after the film bonding step with, and then bonds the frame body forming area (310) to the first surface (211) of the corresponding busbar assembly forming area (210),
wherein the cutting step is configured to cut, after the flat plate bonding step, the busbar assembly forming area (210) and the frame body forming area (310), which are bonded with each other, from the busbar-directed conductive metal flat plate (200) and the frame body-directed flat plate (300).

12. The method for manufacturing the busbar assembly (1-4) according to any one of claims 6 to 10,
wherein the busbar-directed conductive metal flat plate (200) integrally includes the plural busbar assembly forming areas (210) arranged in series in a first direction along the longitudinal direction of the slit (215(1),215(2)), and connection areas (230) each of which connects between the adjacent busbar assembly forming areas (210), and
wherein the slit (215(1), 215(2)) formed in one busbar assembly forming area (210A) has one side in the longitudinal direction extending into one connection area (230A(1)) connected to one side of the one busbar assembly forming area (210A) in the first direction, and another side in the longitudinal direction extending into another connection area (230A(2)) connected to another side of the one busbar assembly forming area (230A) in the first direction.

13. The method for manufacturing the busbar assembly (1,2) according to claim 7 or 11,
wherein the busbar-directed conductive metal flat plate (200) integrally includes the plural busbar assembly forming areas (210) arranged in series in a first direction along the longitudinal direction of the slit (215(1),215(2)), and connection areas (230) each of which connects between the adjacent busbar assembly forming areas (210),
wherein the slit (215(1), 215(2)) formed in one busbar assembly forming area (210A) has one side in the longitudinal direction extending into one connection area (230A(1)) connected to one side of the one busbar assembly forming area (210A) in the first direction, and another side in the longitudinal direction extending into another connection area (230A(2)) connected to another side of the one busbar assembly forming area (230A) in the first direction, and
wherein the frame body-directed flat plate (300) integrally includes the plural frame body forming areas (310) arranged in series in the first direction at the same pitch as the plural busbar assembly forming areas (210), and connection areas (330) each of which connects between the frame body forming areas (310) adjacent in the first direction.
